# EUROPEAN PATENT APPLICATION

(11) **EP 1 175 127 A1**
(43) Date of publication of application: **23.01.2002**
(21) Application number: 00976349.1
(22) Date of filing: 20.11.2000
(51) Int. Cl.: H05B 3/00, H05B 3/20, H01L 21/027

(54) **CERAMIC HEATER**

(30) Priority: 29.12.1999 JP 37720699; 04.01.2000 JP 2000000149
(71) Applicant: IBIDEN CO., LTD., Ogaki-shi Gifu-ken 503-0917 (JP)
(72) Inventor: Ito, Yasutaka, Ibiden Co., Ltd., Ibi-gun, Gifu 501-0695 (JP); Furukawa, Masakazu, Ibiden Co., Ltd., Ibi-gun, Gifu 501-0695 (JP); Hiramatsu, Yasuji, Ibiden Co., Ltd., Ibi-gun, Gifu 501-0695 (JP)
(74) Representative: Gillard, Marie-Louise
(86) International application number: JP0008154
(87) International publication number: WO0150818

(57) **Abstract**

An objective of the present invention is to provide a ceramic heater making it possible to heat an object to be heated, such as a silicon wafer, uniformly. The ceramic heater of the present invention is a ceramic heater wherein a heating element is formed on a surface of a ceramic plate or inside the ceramic plate, wherein: a bottomed hole is made, being directed from the opposite side to a heating surface for heating an object to be heated, toward the heating surface; the bottom of said bottomed hole is formed relatively nearer to the heating surface than the heating element; and a temperature-measuring element is set up in this bottomed hole.

## Description

### Technical Field

The present invention relates to a ceramic heater for drying, sputtering or the like, used mainly in the semiconductor industry, and particularly to a ceramic heater wherein the temperature thereof can easily be controlled and the temperature uniformity of its heating surface is superior.

### Background Art

A semiconductor product is produced through the steps of forming a photosensitive resin as an etching resist on a silicon wafer and subjecting the silicon wafer to etching, and the like steps.

This photosensitive resin is liquid, and is applied onto a surface of the silicon wafer, using a spin coater or the like. After the application, the resin must be dried. Thus, the silicon wafer subjected to the application process is put on a heater and heated.

Hitherto, as a heater made of metal and used for such a purpose, a heater wherein heating elements are arranged on the back surface of an aluminum plate is adopted.

However, such a heater made of metal has the following problems.

First, the thickness of the heater plate must be as thick as about 15 mm since the heater is made of metal. This is because a bend, a strain and so on are generated due to thermal expansion resulting from heating so that a silicon wafer put on the metal plate is damaged or inclined in case of a metal plate being thin . However, if the thickness of the heater plate is made thick, the heater becomes heavy and bulky.

Also, heating temperature is controlled by changing the voltage or amperage applied to the heating elements. However, since the metal plate is thick, the temperature of the heater plate does not follow the change in the voltage or amperage promptly. Thus, such a problem that the temperature cannot be easily controlled is caused.

Thus, as suggested in JP Kokai Hei 8-8247, there is a technique suggested, wherein a nitride ceramic on which heating elements are formed is used to perform temperature-control while measuring the temperature near the heating elements.

### Summary of the Invention

However, when such a technique is used to heat a silicon wafer, a problem that the silicon wafer is damaged by thermal shock resulting from a temperature-difference on the surface of the heater is caused.

Thus, the inventors made eager investigations on causes of the damage of the silicon wafer. As a result, the inventors have found out that the occurrence of the damage of the silicon wafer, in spite of performing temperature-control, is owing to the following unexpected fact: when the temperature near the heating elements is measured, the measured temperature is not necessarily reflects the temperature of the heating surface for the silicon wafer, therefore, a temperature-difference is generated in some places of the silicon wafer and, thus the silicon wafer is damaged.

The inventors have also found out a new fact that such non-uniformity of the temperature is significant in ceramics having a high thermal conductivity, such as nitride ceramic and carbide ceramic.

Thus, repeating further investigations, the inventors have found out that by measuring the temperature of a portion nearer to the silicon wafer and heating the silicon wafer on the basis of the thus obtained result, a temperature-difference on the heating surface for the silicon wafer can be made small so that the ceramic plate can be prevented from being damaged, and have made the present invention which has, as the subject matter thereof, the following contents.

That is, a ceramic heater of the first aspect of the present invention is a ceramic heater comprising a ceramic plate and a heating element formed on a surface of the ceramic plate or inside thereof,
wherein:
a bottomed hole is made, being directed from the opposite side to a heating surface for heating an object to be heated, toward the heating surface;
the bottom of the bottomed hole is formed relatively nearer to the heating surface than the heating element;
and a temperature-measuring element is set up in this bottomed hole.

In the above-mentioned ceramic heater, the distance between the bottom of the bottomed hole and the heating surface is desirably from 0.1 mm to 1/2 of the thickness of the ceramic plate.

The ceramic constituting the ceramic heater is desirably a nitride ceramic or a carbide ceramic.

The heating element of the ceramic heater is desirably divided into at least two circuits.

The heating element of the ceramic heater desirably has a section in a flat shape.

A ceramic heater of the second aspect of the present invention is a ceramic heater comprising a ceramic plate and a heating element formed on a surface of the ceramic plate or inside thereof, the ceramic heater being equipped with:
a temperature-measuring element for measuring the temperature of the ceramic plate;
a control unit for supplying electric power to the heating element;
a memory unit for memorizing the data of a temperature measured by the temperature-measuring element; and
an operation unit for calculating electric power required for the heating element from the temperature data,
wherein:
a bottomed hole is made, being directed from the opposite side to a heating surface for heating an object to be heated, toward the heating surface;
the bottom of the bottomed hole is formed relatively nearer to the heating surface than the heating element;
and a temperature-measuring element is set up in this bottomed hole.

It is desired that in the ceramic heater, the heating element is divided into at least two circuits and different electric powers are supplied to the respective circuits.

It is desired that in the ceramic heaters according to the first and second of aspects of the present invention, the temperature-measuring element is a sheath type thermocouple, and is pressed on the bottom portion of the bottomed hole.

It is also desired that the temperature-measuring element is pressed thereon, by means of an elastic body or a screw.

It is also desired that the temperature-measuring element is sealed in the bottomed hole with an insulator.

### Brief Description of Drawings

FIG. 1 is a bottom surface view that schematically shows an example of a ceramic heater of the first aspect of the present invention.
FIG. 2 (a) is a block figure that schematically shows an example of a ceramic heater of the second aspect of the present invention, and FIG. 2(b) is a partially enlarged sectional view of this ceramic heater.
FIG. 3 is a block figure that schematically shows another example of a ceramic heater of the second aspect of the present invention.
FIG. 4(a) is a sectional view that schematically shows an example of a ceramic heater wherein a temperature-measuring element is set up, and FIG. 4 (b) is an enlarged bottom surface view showing the shape of a bottomed hole.
FIG. 5(a) is a sectional view that schematically shows another example of the ceramic heater wherein a temperature-measuring element is set up, and FIG. 5(b) is an enlarged bottom surface view showing the shape of a bottomed hole.
FIG. 6 is a graph showing temperature profiles of a ceramic heater according to Example 4.
FIG. 7 is a graph showing electric power profiles of a ceramic heater according to Example 4.

| Explanation of symbols | |
|---|---|
| 10, 20, 40 | a ceramic heater |
| 11, 21, 41, 61, 71 | a heater plate |
| 12, 22, 42, 62, 72 | a heating element |
| 13, 23, 43 | a terminal pin |
| 14, 24, 44 | a bottomed hole |
| 15, 25, 45 | a through hole |
| 19 | a silicon wafer |
| 21a, 41a | a heating surface |
| 21b, 41b | a bottom surface |
| 26, 46 | a supporting pin |
| 27, 47, 67 | a thermocouple |
| 28 | a conductor filled through hole |
| 29, 49 | a control unit |
| 30, 50 | a memory unit |
| 31, 51 | an operation unit |
| 66 | a cylinder |
| 610, 710 | a bottomed hole |

### Disclosure of the Invention

The ceramic heater of the first aspect of the present invention is a ceramic heater comprising a ceramic plate and a heating element formed on a surface of the ceramic plate or inside thereof,
wherein:
a bottomed hole is made, being directed from the opposite side to a heating surface for heating an object to be heated, toward the heating surface;
the bottom of the bottomed hole is formed relatively nearer to the heating surface than the heating element;
and a temperature-measuring element is set up in this bottomed hole.

According to the ceramic heater of the first aspect of the present invention, a place for temperature-measurement is nearer to a heating surface for an object to be heated (a silicon wafer) than the heating element. Therefore, the temperature of the object to be heated can be more correctly measured. By adjusting the heating condition of the heating element on the basis of this measured result of the temperature, the object to be heated can be uniformly heated.

A nitride ceramic or a carbide ceramic has a smaller thermal expansion coefficient than metals and a far higher mechanical strength than metals. Thus, even if a ceramic plate (referred to as a heater plate hereinafter) is made thin, the heater plate is not warped or distorted by heating. As a result, the heater plate can be made thin and light. Since the thermal conductivity of the heater plate is high and the heater plate itself is thin, the surface temperature of the heater plate follows a change in the temperature of the heating element promptly. In other words, by changing voltage or amperage to change the temperature of the heating element, the surface temperature of the heater plate can be controlled.

It is desired: that in the ceramic heater, the heating element is formed on a surface which is one main face of the heater plate and the opposite face is made to be a heating surface for heating an object to be heated, such as a silicon wafer; or that the heating element is formed, to be biased from the center toward the side of one main face inside the heater plate and the surface farther from the heating element is made to be a heating surface.

By setting the position where the heating element is formed in this way, heat generated from the heating element diffuses all over the heater plate while the heat is conducted. As a result, the temperature distribution in the surface for heating an object to be heated (a silicon wafer) is made uniform so that the temperatures in respective portions of the object are made uniform.

The heating is performed by putting the object to be heated onto the heater plate, or by holding the object at a given distance apart from the heater plate.

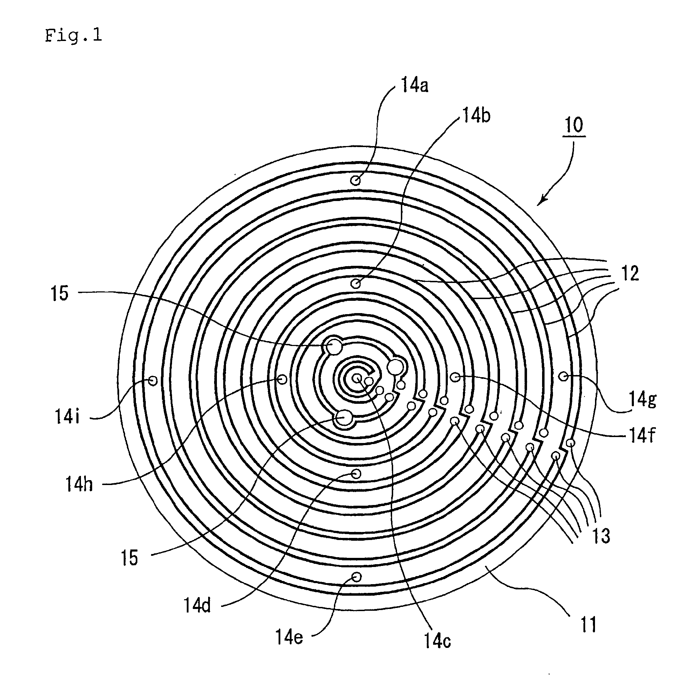

FIG. 1 is a bottom surface view that schematically shows an example of a ceramic heater of the first aspect of the present invention.

A heater plate 11 is formed into a disc form. Heating elements 12 are formed into a pattern of concentric circles on the bottom surface of the heater plate 11 in order to heat a heating surface (an opposite face of the illustrated bottom surface) of the heater plate 11 in such a manner that the temperature in the whole of the heating surface thereof becomes uniform. As to these heating elements 12, two concentric circles near to each other, as one set, are connected into one line. Terminal pins 13, which will be input/output terminals, are connected to two ends thereof. Through holes 15 into which supporting pins (not illustrated) are inserted are formed in areas near the center. Bottomed holes 14a to 14i into which temperature-measuring elements are inserted are also formed.

In the ceramic heater 10, the thickness of the heater plate 11 is preferably 0.5 to 5 mm. If the thickness is thinner than 0.5 mm, the strength thereof is lowered so that the heater plate is easily damaged. On the other hand, if the thickness is thicker than 5 mm, heat is not easily conducted so that heating efficiency is lowered.

The ceramic constituting the ceramic heater 10 is desirably a nitride ceramic or a carbide ceramic.

Examples of the nitride ceramic include aluminum nitride, silicon nitride, boron nitride and titanium nitride. These may be used alone or in combination of two or more.

Examples of the carbide ceramic include silicon carbide, zirconium carbide, titanium carbide, tantalum carbide and tungsten carbide. These may be used alone or in combination of two or more.

Among these, aluminum nitride is most preferred. The reasons for this are as follows: its thermal conductivity is highest, that is, 180 W/m · K and aluminum nitride has superior temperature-following property, on the other hand, since aluminum nitride easily causes non-uniformity of temperature distribution, it is necessary to adopt the structure wherein the temperature-measuring element is formed as is in the present invention.

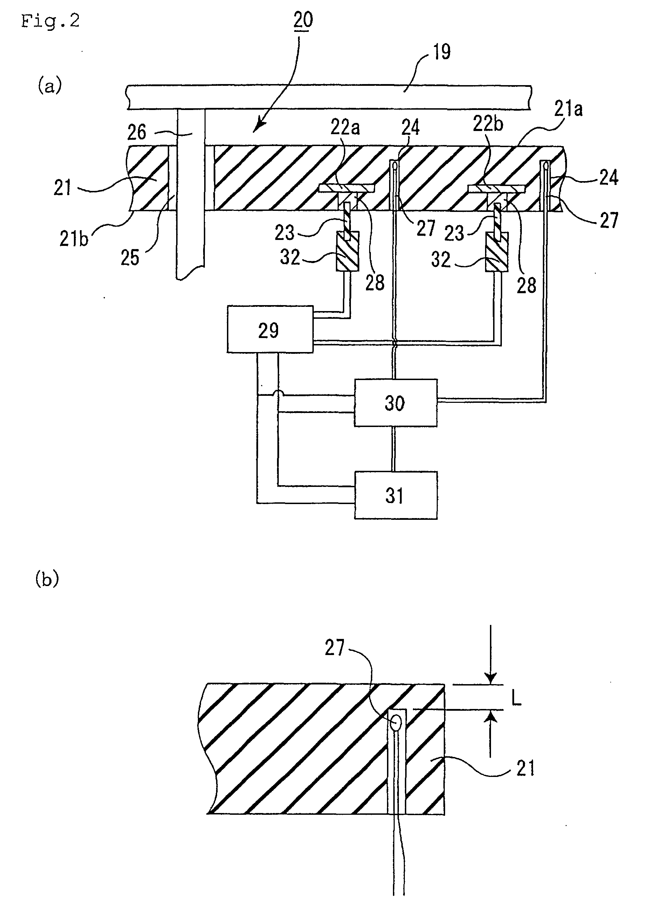

In the ceramic heater 10 of the first aspect of the present invention, the distance L (reference to FIG. 2(b)) between the bottom of the bottomed holes 14a to 14i and the heating surface is desirably from 0.1 mm to 1/2 of the thickness of the ceramic plate. If the distance between the bottom of the bottomed holes 14a to 14i and the heating surface is below 0.1 mm, heat is radiated so that a temperature distribution is produced on the heating surface for a silicon wafer. On the other hand, if the distance is over 1/2 of the thickness of the ceramic plate, the influence of the temperature of the heating elements over the control apt to be significant so that a temperature distribution is produced on the heating surface for the silicon wafer.

Examples of the temperature-measuring element include a thermocouple and a platinum temperature-measuring resistance, and a thermistor.

Examples of the thermocouple include K, R, B, S, E, J and T type thermocouples, as described in JIS-C-1602 (1980). Among these, the K type thermocouple is preferred.

Desirably, the size of the connecting portion of the thermocouple is equal to or more than the diameter of its strand wire, and is 0.5 mm or less. If the connectingportion is large, the thermal capacity is large so that the response becomes poor. Incidentally, making the size smaller than the diameter of the strand wire is difficult.

The diameter of the bottomed holes 14a to 14i is desirably 0.3 to 0.5 mm. If the diameter is too large, the heat radiant property becomes too large. If the diameter is too small, the processability becomes poor so that the distance between the processing surface and the holes cannot be made uniform.

As shown in FIG. 1, the bottomed holes 14a to 14i are desirably arranged into a cross form, and symmetrically with respect to the center of the heater plate 11. Such arrangement makes it possible to measure the temperature in the whole of the heating surface.

The temperature-measuring elements may be bonded to the bottoms of the bottomed holes 14a to 14i, using gold solder, silver solder and the like. The temperature-measuring elements may be inserted into the bottomed holes 14a to 14i and then the holes may be sealed with an insulator such as a heat resistant resin or a ceramic. The both manners may be used together.

Examples of the heat resistant resin may be thermosetting resins, in particular, epoxy, polyimide, bismaleimide-triazine and silicone resins. These resins may be used alone or in combination of two or more. The sealing may be performed using a ceramic such as silica sol or alumina sol.

The gold solver is desirably at least one selected from an alloy of 37 to 80.5 % by weight of Au-63 to 19.5 % by weight of Cu, an alloy of 81.5 to 82.5 % by weight of Au-18.5 to 17.5 % by weight of Ni. These have a melting temperature of 900 °C or higher and are not easily melted even at a high temperature range.

The silver solder that can be used may be, for example, a Ag-Cu type.

As shown in FIG. 1, the heating elements 12 are desirably divided into at least two circuits, and more desirably divided into 2 to 10 circuits. By the division into the circuits, each electric power supplied to the respective circuits can be controlled to change the calorific value thereof so that the temperature of the heating surface for a silicon wafer can be adjusted.

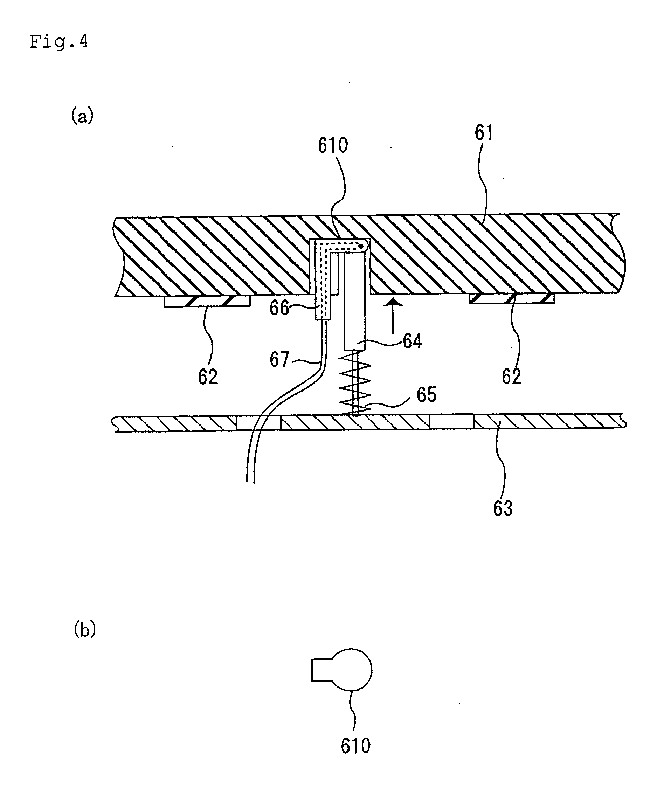

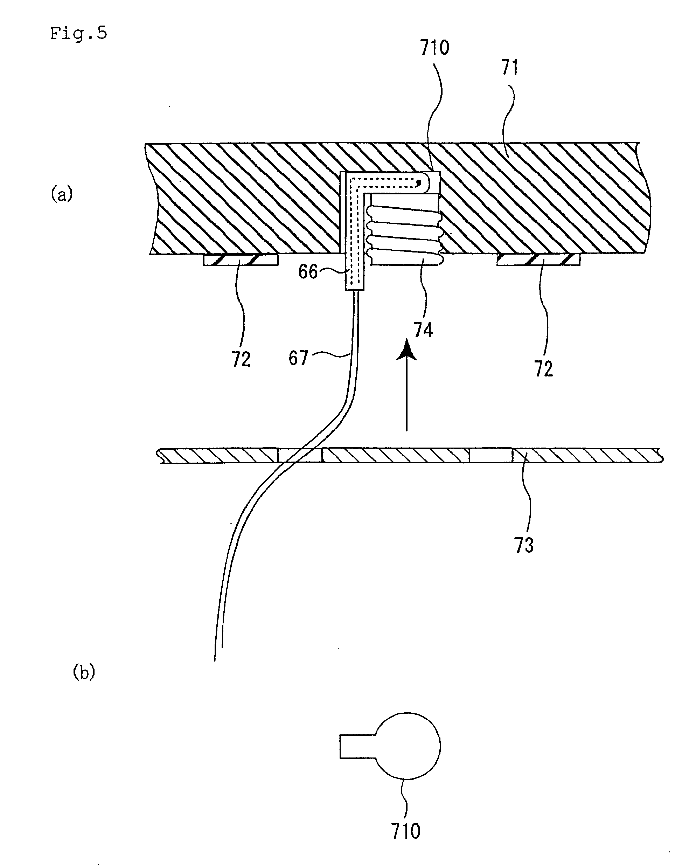

FIGS. 4,5 are views each of which shows a method for fixing a temperature-measuring element. FIGs. 4(a),5(a) are sectional views each of which shows the vicinity of a bottomed hole. FIGs. 4(b), 5(b) are enlarged bottom surface views each of which shows a shape of the bottomed hole.

As shown in FIG. 4, when the temperature-measuring element is fixed, the temperature-measuring element may be pressed on the bottom surface of a bottomed hole 610, using an elastic body such as a coil spring 65. As shown in FIG. 5, the temperature-measuring element may be pressed against the bottom surface of a bottomed hole 710, using a bolt 74. As the elastic body, the coil spring, a plate spring and the like may be used.

When the temperature-measuring element is fixed with a resin, a ceramic, a solder material or the like, it is apprehended that such a material will deteriorate thermally so that the temperature-measuring element may fall away. However, in the case that a physical method such as pressing is used, such a problem is not caused. Thus, such a case is favorable. As shown in FIGs. 4,5, in the case that fixing based on pressing or the like is performed and a thermocouple is used as the temperature-measuring element, it is desired to use a sheath type thermocouple wherein the thermocouple is inserted into a cylinder and the surrounding of the thermocouple is filled with insulating powder such as alumina powder. This is because: the structure of this type makes it possible to prevent the thermocouple from being damaged.

Examples of the pattern of the heating elements 12 include the concentric circuits shown in FIG. 1, a spiral, eccentrics, and curved lines.

In the case that the heating elements 12 are formed on the surface of the heater plate 11 in the present invention, adopting the following method is preferred: a method of applying a conductor containing paste containing metal particles to the surface of the heater plate 11 to form a conductor containing paste layer having a given pattern, and firing this to sinter the metal particles on the surface of the heater plate 11. When: the metal particles are melted and adhered to each other; and the metal particles and the ceramic are melted and adhered to each other upon the sintering of the metal, the sintering is sufficient.

When the heating elements 12 are formed on the surface of the heater plate 11 as shown in FIG. 1, the thickness of the resistance heating elements 12 is preferably 1 to 30 µm and more preferably 1 to 10 µm. When the heating elements are formed inside the heater plate 11, the thickness thereof is preferably 1 to 50 µm.

When the heating elements 12 are formed on the surface of the heater plate 11, the width of the heating elements is preferably 0.1 to 20 mm and more preferably 0.1 to 5 mm. When the heating elements are formed inside the heater plate 11, the width of the heating elements is preferably 5 to 20 µm.

The resistance value of the heating elements 12 can be changed dependently on their width or thickness. The above-mentioned ranges are however most practical. The resistance value becomes larger as the heating elements become thinner and narrower. The thickness and the width of the heating elements 12 become larger in the case that the heating elements 12 are formed inside the heater plate 11. The reason for this is as follows:
when the heating elements 12 are formed inside, the distance between the heating surface and the heating elements becomes short so that the uniformity of the temperature on the surface becomes poor, thus, it is necessary to make the width of the heating elements 12 themselves large;
also, when the heating elements are formed inside, it is unnecessary to consider the adhesiveness to any ceramic, for example, a nitride ceramic. Therefore, it is possible to use a high melting point metal such as tungsten or molybdenum, or a carbide of tungsten, molybdenum and the like. Thus, it becomes possible to make the resistance value thereof high. Therefore, the thickness itself may be made large in order to prevent disconnection and so on.

For these reasons, the heating elements 12 desirably have the above-mentioned thickness and width.

The heating elements 12 may have a rectangular section or an elliptical section. They desirably have a flat section. This is because: in case of the flat section, heat is more easily radiated toward the heating surface. Thus, a temperature distribution on the heating surface is not easily generated.

The aspect ratio (the width of the heating element/the thickness of the heating element) of the section is desirably 10 to 5000.

Adjustment thereof into this range makes it possible to increase the resistance value of the heating elements 12 and keep the uniformity of the temperature on the heating surface.

In the case that the thickness of the heating elements 12 is made constant: if the aspect ratio is smaller than the above-mentioned range, the amount of heat conduction toward the wafer-heating surface of the heater plate 11 becomes small so that a thermal distribution similar to the pattern of the heating elements 12 is generated on the heating surface; on the other hand, if the aspect ratio is too large, the temperature of the portions just above the centers of the heating elements 12 becomes high so that a thermal distribution similar to the pattern of the heating elements 12 is also generated on the heating surface. Accordingly, if temperature distribution is considered, the aspect ratio of the section is preferably 10 to 5000.

When the heating elements 12 are formed on the surface of the heater plate 11, the aspect ratio is desirably 10 to 200. When the heating elements 12 are formed inside the heater plate 11, the aspect ratio is desirably 200 to 5000.

The aspect ratio becomes larger in the case that the heating elements 12 are formed inside the heater plate 11. This is based on the following reason. If the heating elements 12 are formed inside, the distance between the heating surface and the heating elements 12 becomes short so that temperature uniformity in the surface becomes poor. It is therefore necessary to make the heating elements 12 themselves flat.

The position where the heating elements 12 are formed to be biased inside the heater plate 11 is desirably at a position near the opposite face side(bottom surface) to the heating surface of the heater plate 11 and at a position exceeds 50% and up to 99% of the distance from a heating surface to the bottom surface.

If the value is 50 % or less, the position is too near to the heating surface so that temperature-dispersion is caused. Conversely, if the value is over 99 %, the heater plate 11 itself warps to damage a silicon wafer.

In the case that the heating elements 12 are arranged inside the heater plate 11, plural heating element formed layers may be formed. In this case, the patterns of the respective layers are preferably disposed in mutually complementary relation so that, when viewed from above the heating surface, the patterns is formed in all areas. A preferred example of such a structure having a staggered arrangement.

The conductor containing paste is not particularly limited, and is preferably a paste comprising not only metal particles or a conductive ceramic for keeping electrical conductivity but also a resin, a solvent, a thickener and so on.

The metal particles are preferably of, for example, a noble metal (gold, silver, platinum or palladium), lead, tungsten, molybdenum, nickel or the like. These may be used alone or in combination of two or more. These metals are not relatively easily oxidized, and have an resistance value sufficient for generating heat.

Examples of the conductive ceramic include carbides of tungsten and molybdenum, for example. These may be used alone or in combination of two or more.

The particle diameter of these metal particles or the conductive ceramic is preferably 0.1 to 100 µm. If the particle diameter is too fine, that is, below 0.1 µm, they are easily oxidized. On the other hand, if the particle diameter is over 100 µm, they are not easily sintered so that the resistance value becomes large.

The shape of the metal particles may be spherical or scaly. When these metal particles are used, they may be a mixture of spherical particles and scaly particles.

In the case that the metal particles are scaly or a mixture of spherical particles and scaly particles, metal oxides between the metal particles are easily retained and adhesiveness between the heating elements 12 and, for example, the nitride ceramic or the like is made sure. Moreover, the resistance value can be made large. Thus, this case is profitable.

Examples of the resin used in the conductor containing paste include epoxy resins and phenol resins. An example of the solvent is isopropyl alcohol. An example of the thickener is cellulose.

It is desired to add a metal oxide to the metal particles in the conductor containing paste and make the heating element 12 into a sintered body of the metal particles and the metal oxide, as described above. By sintering the metal oxide together with the metal particles in this way, the nitride ceramic or the carbide ceramic, which is the heater plate, can be closely adhered to the metal particles.

The reason why the adhesiveness to the nitride ceramic or the carbide ceramic is improved by mixing the metal oxide is unclear, but would be based on the following. The surface of the metal particles, or the surface of the nitride ceramic or the carbide ceramic is slightly oxidized so that an oxidized film is formed thereon. Pieces of these oxidized films are sintered and integrated with each other through the metal oxide so that the metal particles and the nitride ceramic or the carbide ceramic are closely adhered to each other.

A preferred example of the metal oxide is at least one selected from the group consisting of lead oxide, zinc oxide, silica, boron oxide (B₂O₃), alumina, yttria, and titania.

These oxides make it possible to improve adhesiveness between the metal particles and the nitride ceramic or the carbide ceramic without increasing the resistance value of the heating elements 12.

When the total amount of the above mentioned metal oxides is set to 100 parts by weight, the weight ratio of the above mentioned lead oxide, zinc oxide, silica, boron oxide (B₂O₃), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The weight ratio is preferably adjusted within the scope that the total thereof is not over 100 parts by weight.

By adjusting the amounts of these oxides within these ranges, the adhesiveness to the nitride ceramic can be particularly improved.

The addition amount of the metal oxides to the metal particles is preferably 0.1 % by weight or more and less than 10 % by weight. The area resistivity when the conductor containing paste having such a structure is used to form the heating elements 12 is preferably from 1 mΩ/□ to 10 Ω/□.

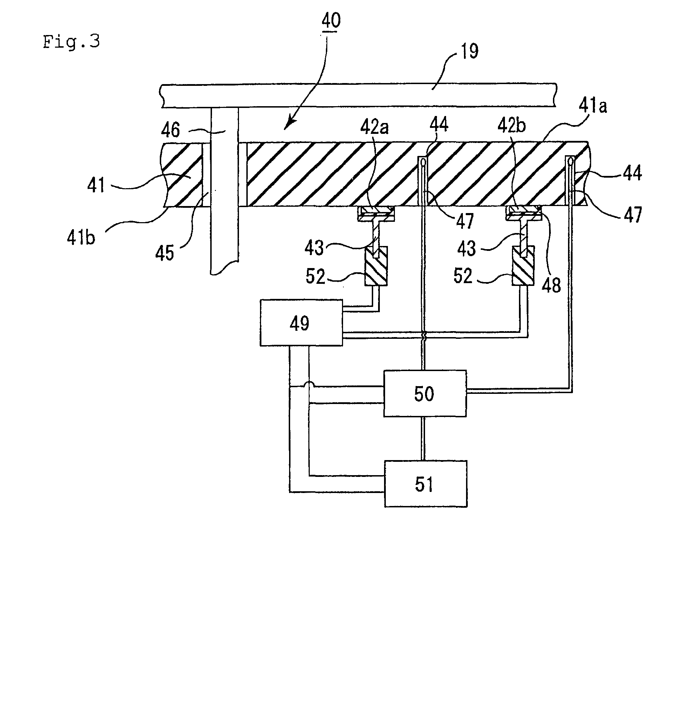

In the case that the heating elements 12 are formed on the surface of the heater plate 11, a metal covering layer (reference to FIG. 3)48 is preferably formed on the surface of the heating elements 12. The metal covering layer prevents a change in the resistance value owing to the oxidization of the inner metal sintered body. The thickness of the formed metal covering layer is preferably from 0.1 to 10 µm.

This is because: the metal used for forming the metal covering layer is not particularly limited if the metal is a metal which is hardly oxidized. Specific examples thereof include gold, silver, palladium, platinum, and nickel. These may be used alone or in combination of two or more. Among these metals, nickel is preferred.

This is because: in the heating element 12, a terminal for connecting to a power source is necessary. This terminal is fixed to the heating element 12 through solder. Nickel prevents solder from being thermally diffused. An example of the connecting terminal is a terminal pin 13 made of koval.

In the case that the heating elements 12 are formed inside the heater plate 11, no coating is necessary since the surface of the heating elements is not oxidized. In the case that the heating elements 12 are formed inside the heater plate 11, a part of the heating elements may be exposed in the surface. It is allowable that conductor filled through holes for connecting to the heating elements are made in portions for the terminals and terminals are connected and fixed to the conductor filled through holes.

In the case that the connecting terminals are connected, an alloy such as silver-lead, lead-tin or bismuth-tin can be used as a solder. The thickness of the solder layer is desirably from 0.1 to 50 µm. This is because this range is a range sufficient for maintaining connection based on the solder.

Electrodes may be embedded in the ceramic plate in the ceramic heater of the present invention so that the ceramic heater can function as an electrostatic chuck. In another case, a chuck top conductor layer is deposited on the surface of the ceramic heater and a guard electrode and a ground electrode may be formed therein so that the ceramic heater can function as a wafer prober.

The following will describe the process for producing a ceramic heater wherein the heating elements 12 are formed on the surface of the heater plate 11 shown in FIG. 1.

### (1) Step of forming the heater plate

If necessary, a sintering aid such as yttria, a binder and so on are blended with powder of a nitride ceramic, such as the above-mentioned aluminum nitride, or a carbide ceramic to prepare a slurry. Thereafter, this slurry is made into a granular form by spray drying or the like. The granule is put into a mold and pressed to be formed into a plate form or the like form. Thus, a raw formed body(green) is formed.

Next, portions that will be the through holes 15 into which supporting pins for supporting a silicon wafer are inserted, and portions that will be the bottomed holes 14a to 14i in which temperature-measuring elements such as thermocouples are buried; are formed in the raw formed body by drilling, blast treatment or the like if necessary.

Next, this raw formed body is heated and fired to be sintered. Thus, a plate made of the ceramic is produced. Thereafter, the plate is made into a given shape to produce the heater plate 11. The shape of the raw formed body may be such a shape that the sintered body can be used as it is. By heating and firing the raw formed body under pressure, the heater plate 11 having no pores can be produced. It is sufficient that the heating and the firing are performed at sintering temperature or higher. The firing temperature is 1000 to 2500 °C for nitride ceramics or carbide ceramics.

### (2) Step of printing a conductor containing paste on the heater plate

A conductor containing paste is generally a fluid comprising metal particles, a resin and a solvent, and has a high viscosity. This conductor containing paste is printed in portions where heating elements are to be arranged, by screen printing or the like, to form a conductor containing paste layer . Since it is necessary that the heating elements make the temperature of the whole of the heater plate uniform, the conductor containing paste is desirably printed into a pattern comprising concentric circles, as shown in FIG. 1.

The conductor containing paste layer is desirably formed in the manner that a section of the heating elements 12 after the firing is rectangular and flat.

### (3) Firing of the conductor containing paste

The conductor containing paste layer printed on the bottom surface of the heater plate 11 is heated and fired to remove the resin and the solvent and sinter the metal particles. Thus, the metal particles are baked onto the bottom surface of the heater plate 11 to form the heating elements 12. The heating and firing temperature is preferably 500 to 1000 °C.

If the above-mentioned metal oxides are added to the conductor containing paste, the metal particles, the heater plate and the metal oxides are sintered to be integrated with each other. Thus, the adhesiveness between the heating elements and the heater plate is improved.

### (4) Step of forming a metal covering layer

A metal covering layer is desirably deposited on the surface of the heating elements 12. The metal covering layer can be formed by electroplating, electroless plating, sputtering or the like. From the viewpoint of mass-productivity, electroless plating is optimal.

### (5) Fitting of terminals and so on

Terminals (terminal pins 13) for connecting to a power source are fitted up to ends of the pattern of the heating elements 12 with solder. Thermocouples are fixed to the bottomed holes 14a to 14i with silver solder, gold solder or the like. The bottomed holes are sealed with a heat resistant resin such as a polyimide to finish the manufacture of the ceramic heater 10.

The following will describe a process for producing a ceramic heater wherein heating elements are formed inside a heater plate.

### (1) Step of forming the heater plate

First, powder of a nitride ceramic or a carbide ceramic is mixed with a binder, a solvent and so on to prepare a paste. This is used to form a green sheet.

As the above-mentioned ceramic powder, aluminum nitride, silicon carbide or the like can be used. If necessary, a sintering aid such as yttria may be added.

As the binder, desirable is at least one selected from an acrylic binder, ethylcellulose, butylcellusolve, and polyvinyl alcohol.

As the solvent, desirable is at least one selected from α-terpineol and glycol.

A paste obtained by mixing these is formed into a sheet form by the doctor blade process, to form a green sheet.

The thickness of the green sheet is preferably 0.1 to 5 mm.

Next, the following are made in the resultant green sheet if necessary: portions which will be through holes into which supporting pins for supporting a silicon wafer are inserted; portions which will be bottomed holes in which temperature-measuring elements such as thermocouples are buried; portions which will be conductor filled through holes for connecting the heating elements to external terminal pins; and so on. After a green sheet lamination that will be described later is formed, the above-mentioned processing may be performed.

### (2) Step of printing a conductor containing paste on the green sheet

A metal paste or a conductor containing paste containing a conductive ceramic is printed on the green sheet.

This conductor containing paste contains metal particles or conductive ceramic particles.

The average particle diameter of tungsten particles or molybdenum particles is preferably 0.1 to 5 µm. If the average particle is below 0.1 µm or over 5 µm, the conductor containing paste is not easily printed.

Such a conductor containing paste may be a composition (paste) obtained by mixing, for example, 85 to 87 parts by weight of the metal particles or the conductive ceramic particles; 1.5 to 10 parts by weight of at least one kind of binder selected from acrylic binders, ethylcellulose, butylcellusolve and polyvinyl alcohol; and 1.5 to 10 parts by weight of at least one solvent selected from α-terpineol and glycol.

### (3) Step of laminating the green sheets

Green sheets on which no conductor containing paste is printed are laminated on the upper and lower sides of the green sheet on which the conductor containing paste is printed.

At this time, the number of the green sheet laminated on the upper side is made larger than that of the green sheet laminated on the lower side to cause the position where the heating elements are formed to be biased toward the bottom surface.

Specifically, the number of the green sheets laminated on the upper side is preferably 20 to 50, and that of the green sheets laminated on the lower side is preferably 5 to 20.

### (4) Step of firing the green sheet lamination

The green sheet lamination is heated and pressed to sinter the ceramic particles and the inner conductor containing paste in the green sheets.

The heating temperature is preferably 1000 to 2000 °C, and the pressing pressure is preferably 100 to 200 kg/cm². The heating is performed in the atmosphere of an inert gas. As the inert gas, argon, nitrogen or the like can be used.

After the firing, bottomed holes into which temperature-measuring elements will be inserted may be made. The bottomed holes can be made by blast treatment such as sandblast after surface-polishing. Terminals are connected to the conductor filled through holes for connecting to the inner heating elements, and then the resultant is heated for reflowing. The heating temperature is suitably 200 to 500 °C.

Furthermore, thermocouples or the like as temperature-measuring elements are inserted and set up with silver solder, gold solder or the like, and then the holes are sealed with a heat-resistant resin such as polyimide to finish the manufacture of the ceramic heater.

The following will describe a ceramic heater of the second aspect of the present invention.

The ceramic heater of the second aspect of the present invention is a ceramic heater comprising a ceramic plate and a heating element formed on a surface of the ceramic plate or inside thereof, the ceramic heater being equipped with:
a temperature-measuring element for measuring the temperature of the ceramic plate;
a control unit for supplying electric power to the heating element;
a memory unit for memorizing the data of a temperature measured by the temperature-measuring element; and
an operation unit for calculating electric power required for the heating element from the temperature data,
wherein:
a bottomed hole is made, being directed from the opposite side to a heating surface for heating an object to be heated, toward the heating surface;
the bottom of the bottomed hole is formed relatively nearer to the heating surface than the heating element;
and a temperature-measuring element is set up in this bottomed hole.

According to the ceramic heater of the second aspect of the present invention, a place for a temperature-measurement is nearer to a heating surface for a silicon wafer than the heating element. Therefore, the temperature of the silicon wafer can be more correctly measured. This correctly measured result of the temperature is memorized in the memory unit, and then an electric power which is going to be supplied to the heating element in order to perform uniform heating is calculated in the operation unit on the basis of the temperature data memorized in the memory unit. On the basis of the calculated result, a voltage for control is applied to the heating element by the control unit. Therefore, the whole of the silicon wafer can be uniformly heated.

A nitride ceramic or a carbide ceramic has a smaller thermal expansion coefficient than metals and a far higher mechanical strength than metals. As a result, the heater plate can be made thin and light. Since the thermal conductivity of the heater plate is high and the heater plate itself is thin, the surface temperature of the heater plate follows a change in the temperature of the heating element promptly.

FIG. 2 (a) is a block figure that schematically shows an example of a ceramic heater of the second aspect of the present invention, and FIG. 2(b) is a partially enlarged sectional view showing a part thereof.

As shown in FIG. 2, in this ceramic heater 20, plural through holes 25 (only one in the figure) are made in a heater plate 21. Supporting pins 26 are inserted into the through holes 25. A silicon wafer 19 is put on the supporting pins 26. By moving the supporting pins 26 upwards or downwards, the silicon wafer 19 can be delivered to a non-illustrated carrier machine, or the silicon wafer 19 can be received from the carrier machine.

By the supporting pins 26, the silicon wafer 19 can be held at a given distance apart from the heater plate 21 and can be heated.

Heating elements 22a and 22b are embedded in the heater plate 21, and the heating elements 22a and 22b are connected, through conductor filled through holes 28, to terminal pins 23 arranged on the bottom surface. The terminal pins 23 are fitted with sockets 32, and the sockets 32 are connected to a control unit 29 having a power source.

Bottomed holes 24 are made, from the side of the bottom surface 21b, in the heater plate 21. Thermocouples 27 are fixed to the bottoms of the bottomed holes 24. The thermocouples 27 are connected to a memory unit 30 so that the temperatures of the respective thermocouples 27 are measured every given interval. Thus, the data can be memorized. This memory unit 30 is connected to a control unit 29 and an operation unit 31. On the basis of the data memorized in the memory unit 30, the operation unit 31 calculates a voltage value and so on which are used for the control. On the basis of this calculation, a certain voltage is applied from the control unit 29 to the respective heating elements 21 so that the temperature on a heating surface 21a can be made uniform.

Respective members (the heater plate 21, the heating elements 22a and 22b, conductor filled through holes 28) constituting the ceramic heater 20, bottomed holes 24 formed in the heater plate 21, and so on are made in the same manner as in the case of the ceramic heater of the first aspect of the present invention. Thus, explanation thereof is omitted herein.

The following will describe the operation of the ceramic heater 20 of the second aspect of the present invention.

First, the control unit 29 is operated so that an electric power is supplied to the ceramic heater 20. As a result, the temperature of the heater plate 21 itself rises, but the surface temperature of the periphery thereof becomes slightly low.

The data measured by the thermocouples 27 are once stored in the memory unit 30. Next, the temperature data are sent to the operation unit 31. In the operation unit 31, temperature-differences ΔT among respective measured points are calculated and further data ΔW necessary for making the temperature on the heating surface 21a uniform are calculated.

For example, in the case that the temperature-difference ΔT is generated between the heating element 22a and the heating element 22b and the temperature of the heating element 22a is lower, operations to obtain electric power data ΔW for making the ΔT to zero are run, this data is transmitted to the control unit 29 and an electric power based on this data is supplied to the heating element 22a to raise the temperature thereof.

Regarding the algorithm for calculating the electric power, a method for calculating the electric power necessary for the rise in the temperature by utilizing the specific heat of the heater plate 21 and the weight of the heated area is most simple. A correction coefficient originating from the pattern of the heating elements may be considered together with these factors. Alternatively, a temperature-rising test is beforehand performed on a specific heating element pattern, and functions among a temperature-measuring position, a supplying electric power and temperature are beforehand obtained. From these functions , the supplying electric power may be calculated . The applying voltage and time corresponding to the electric power calculated in the operation unit 31 are transmitted to the control unit 29. On the basis of these values, electric powers are supplied to the respective heating elements 22 by the control unit 29.

FIG. 3 is a block figure that schematically shows another example of a ceramic heater of the second aspect of the present invention.

In a ceramic heater 40 shown in FIG. 3, heating elements 42a and 42b are formed on a bottom surface 41b of a heater plate 41, and metal covering layers 48 are formed around the heating elements 42a and 42b.

A terminal pin 43 is connected and fixed to each of the heating elements 42a and 42b through the metal covering layer 48. The terminal pin 43 is fitted with a socket 52. This socket 52 is connected to a control unit 29 having a power source. Other elements are formed in the same way as in the ceramic heater shown in FIG. 2.

The ceramic heater 40 shown in FIG. 3 operates in the same way as the ceramic heater 20 shown in FIG. 2. The temperatures of thermocouples 42a and 42b are measured every given interval. Thus, the data is memorized in the memory unit 50. From the data, a voltage value and so on for control are calculated in the operation unit 51. On the basis of these, a certain amount of voltage is applied from the control unit 49 to the heating elements 42a,42b so that the temperature in the whole of the heating surface 41a of the ceramic heater 40 can be made uniform.

### Best Mode for Carrying Out the Invention

The present invention will be described in more detailed hereinafter.

### (Example 1) Manufacture of a ceramic heater made of aluminum nitride (reference to FIG. 1)

(1) A composition made of 100 parts by weight of aluminum nitride powder (average particle diameter: 1.1 µm), 4 parts by weight of yttria (average particle diameter: 0.4 µm), 12 parts by weight of an acrylic binder and an alcohol was subjected to spray-drying to make granular powder.
(2) Next, this granular powder was put into a mold and formed into a flat plate form to obtain a raw formed body (green) . This raw formed body was drilled to form: portions which would be through holes 15, into which supporting pins for the silicon wafer are inserted; and portions (diameter: 1.1 mm, and depth: 2 mm) which would be bottomed holes 14a to 14i, in which thermocouples are buried.
(3) The raw formed body subjected to the above-mentioned working treatment was hot-pressed at 1800 °C and a pressure of 200 kg/cm² to obtain a nitride aluminum plate having a thickness of 3 mm.
   Next, this plate was cut out into a disk having a diameter of 210 mm to obtain a plate (heater plate) 11 made of the ceramic.
(4) A conductor containing paste was printed on the heater plate 11 obtained in the step (3) by screen printing. The pattern of the printing was made to a pattern of concentric circles as shown in FIG. 1.
   The conductor containing paste was Solvest PS603D made by Tokuriki Kagaku Kenkyu-zyo, which is used to form plated through holes in printed circuit boards.
   This conductor containing paste was a silver-lead paste and containing 7.5 parts by weight of metal oxides comprising lead oxide (5 % by weight) , zinc oxide (55% by weight) , silica (10% by weight), boron oxide (25% by weight) and alumina (5% by weight) per 100 parts by weight of silver. The silver particles had an average particle diameter of 4.5 µm, and were scaly.
(5) Next, the heater plate 11 on which the conductor containing paste was printed was heated and fired at 780 °C to sinter silver and lead in the conductor containing paste and bake them onto the heater plate 11. Thus, heating elements 12 were formed. The silver-lead heating elements 12 had a thickness of 5 µm, a width of 2.4 mm and a area resistivity of 7.7 mΩ/□.
(6) The heater plate 11 formed in the step (5) was immersed into an electroless nickel plating bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer (nickel layer) having a thickness of 1 µm on the surface of the silver-lead heating elements 12.
(7) A silver-lead solder paste (made by Tanaka Kikinzoku Kogyo CO.) was printed by screen printing on portions to which terminal for attaining connection to a power source were attached, to form a solder layer.
   Next, terminal pins 13 made of koval were put on the solder layer and heated at 420 °C for reflowing to attach the terminal pins 13 onto the surface of the heating elements 12.
(8) Thermocouples for temperature-control were connected with a gold solder of 81.7Au-18.3Ni (heated at 1030 °C and fused) , to obtain a ceramic heater 10.

### (Example 2) Manufacture of a ceramic heater made of silicon carbide

A ceramic heater made of silicon carbide was manufactured in the same way as in Example 1 except that silicon carbide having an average particle diameter of 1.0 µm was used, sintering temperature was set to 1900 °C, and the surface of the resultant heater plate was fired at 1500 °C for 2 hours to form a SiO₂ layer having a thickness of 1 µm on the surface. The thermocouples were sealed by curing a polyimide resin at 120 °C.

### (Example 3) Manufacture of a ceramic heater having heating elements inside thereof

(1) A paste obtained by mixing 100 parts by weight of aluminum nitride powder (made by Tokuyama Corp., average particle diameter: 1.1 µm), 4 parts by weight of yttria (average particle diameter: 0.4 µm), 11.5 parts by weight of an acrylic binder, 0.5 part by weight of a dispersant, and 53 parts by weight of alcohols comprising 1-butanol and ethanol was formed into a green sheet having a thickness of 0.47 µm by the doctor blade process.
(2) Next, this green sheet was dried at 80 °C for 5 hours, and was subjected to punching to make portions which would be through holes 15 having diameters of 1.8 mm, 3.0 mm and 5.0 mm, respectively, into which silicon wafer supporting pins are inserted, and portions which would be conductor filled through holes for connection to terminal pins.
(3) 100 parts by weight of tungsten carbide particles having an average particle diameter of 1 µm, 3.0 parts by weight of an acrylic binder, 3.5 parts by weight of α-terpineol solvent, and 0.3 part by weight of a dispersant were mixed to prepare a conductor containing paste A.
   100 parts by weight of tungsten particles having an average particle diameter of 3 µm, 1.9 parts by weight of an acrylic binder, 3.7 parts by weight of α-terpineol solvent, and 0.2 part by weight of a dispersant were mixed to prepare a conductor containing paste B.
   The conductor containing paste A was printed on the green sheet by screen printing, to form a conductor containing paste layer. The printed pattern was made to a pattern of concentric circles as shown in FIG. 1. The conductor containing paste B was filled into the through holes which would be conductor filled through holes for connection to terminal pins.
   Thirty seven green sheets on which no tungsten paste was printed were stacked on the upper side (heating surface) of the green sheet subjected to the above-mentioned treatment, and 13 green sheets on which no tungsten paste was printed were stacked on the lower side thereof, and then the green sheets were laminated at 130 °C and a pressure of 80 kg/cm².
(4) Next, the resultant lamination was degreased at 600 °C in nitrogen gas for 5 hours, and hot-pressed at 1890 °C and a pressure of 150 kg/cm² for 3 hours to obtain an aluminum nitride plate 3 mm in thickness. This was cut out into a disc of 230 mm in diameter to prepare a ceramic heater having therein heating elements having a thickness of 6 µm and a width of 10 mm.
(5) Next, the plate obtained in the step (4) was grinded with diamond grindstone, and then a mask was put thereon to make bottomed holes (diameter: 1.2 mm, and depth: 2.0 mm) for thermocouples in the surface by blast treatment with SiC or the like.
(6) Furthermore, a part of the through holes which would be conductor filled through holes was hollowed out, and a gold solder comprising Ni-Au was employed and heated for reflowing at 700 °C, so as to connect terminal pins made of koval to the concave portions.
   Regarding the connection of the terminal pins, a structure, wherein a support of tungsten supports at three points, is desirable. This is because the reliability of the connection can be kept.
(8) Next, thermocouples for temperature-control were buried in the bottomed holes and then the holes were sealed with silica sol (made by Toagosei Co., Ltd., Aron ceramic). The sol was converted into gel at 120 °C to finish the manufacture of the ceramic heater.

### (Example 4) Control of the temperature of a ceramic heater

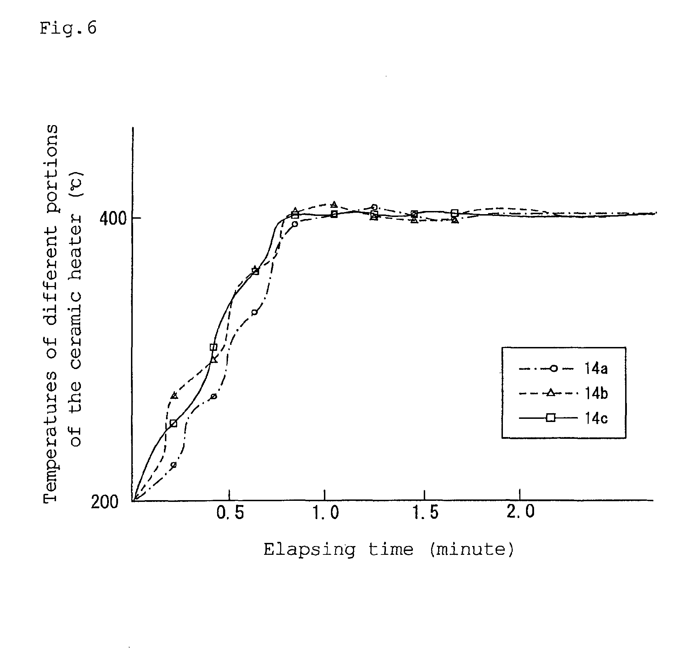

(1) A temperature-adjusting equipment (made by Omron Corp., E5ZE) equipped with a control unit having a power source, a memory unit, and an operation unit was prepared to connect wirings from the control unit to the ceramic heater 10 (reference to FIG. 1) manufactured in Example 1 through the terminal pins 13, and put a silicon wafer on this ceramic heater 10.
(2) Next, a voltage was applied to this ceramic heater 10, and the temperature thereof was once raised to 200 °C. The temperature was further raised up to 200 to 400 °C, and then the temperature was measured with the thermocouples arranged in the bottomed holes 14a to 14c shown in FIG. 1. The measured results are shown in FIG. 6. In FIG. 6, the vertical axis represents temperature and the horizontal axis represents elapsing time.

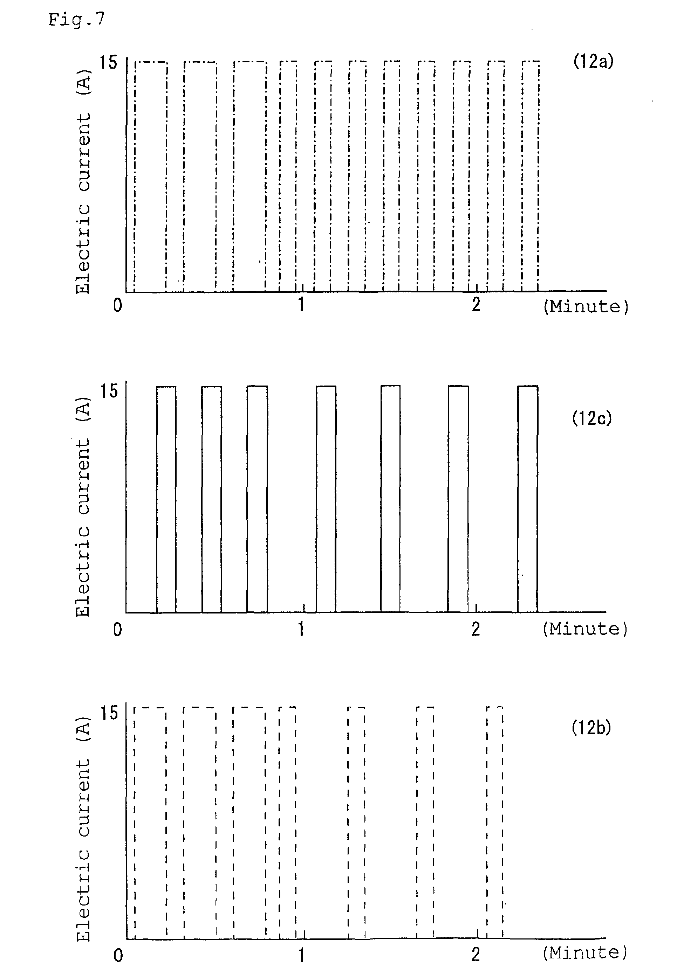

Profiles of electric powers (represented by current values) supplied to the heating elements 12a, 12b and 12c are shown in FIG. 7. In FIG. 7, the vertical axis represents amperage, and the horizontal axis represents elapsing time.

The silicon wafer put on this ceramic heater 10 was not damaged in the process of the heating, and was uniformly heated.

### (Example 5)

A ceramic heater was manufactured in the same way as in Example 1 except that the following points were different.

That is: first, sheath type thermocouples were used as the thermocouples. In each of the thermocouples, a K type thermocouple 67 was inserted into a cylinder 66 made of stainless steel and the surrounding of the thermocouple was filled with MgO power and alumina powder. As shown in FIG. 4(a), this cylinder 66 was crooked in a substantially right angle. As shown in FIG. 4(b), the shape of each bottomed hole 610 was made into a keyhole shape, as viewed from the above. The structure: wherein a rod shaped body 64 made of stainless steel was fixed to the tip of a coil spring 65 made of stainless steel; was adopted. The crooked portion of the cylinder 66 was fixed onto the bottomed holes 610 by pressing the crooked portion against the bottom surface of the bottomed holes 610 by means of the rod shaped body 64. The coil spring 65 was attached to a bottom plate 63 of a supporting case (casing) for a ceramic plate 61.

### (Example 6)

A ceramic heater was manufactured in the same way as in Example 1 except that the following points were different.

As shown in FIG. 5, sheath type thermocouples having the same structure as is in the case of Example 5 were used as the thermocouples. Moreover, in the same way as in the case of Example 5, the shape of bottomed holes 710 was made into a keyhole shape, as viewed from the above. The side wall faces thereof were drilled to make thread grooves. The cylinders 66 having the sheath type thermocouples were inserted into the bottomed holes 710, and bolts 74 made of stainless steel were screwed in so as to fix the crooked portions of the cylinders 66 onto the bottomed holes 610 by pressing the crooked portion against the bottom surface of the bottomed holes 610.

### (Comparative Example 1)

A ceramic heater was manufactured in the same way as in Example 3 except that bottomed holes were formed in such a manner that the bottom surfaces thereof would be at a level corresponding to 74 % of the thickness of the ceramic plate from the heating surface thereof, that is, at the same level as the heating element formed surface, and then the thermocouples were buried in the bottomed holes to solder the thermocouples with Au-Ni.

### (Comparative Example 2)

A ceramic heater was manufactured in the same way as in Example 1 except that the thermocouples were soldered to the heating element formed surface, that is, the bottom surface, with Au-Ni.

Each temperature of the ceramic heaters according to Examples 1 to 6 and Comparative Examples 1,2 was raised to 200 °C. A difference between the highest temperature and the lowest temperature thereof was measured with a thermoviewer.
Then, the silicon wafer having a thermocouple with a temperature of 25 °C was put on the ceramic heater wherein the temperature thereof was raised to 200 °C. A time(recovery time)until the temperature thereof returned to 200 °C, which was the original temperature, was measured. The results are shown in Table 1.

**Table 1**

| | Temperature-difference (°C) | Recovery time (seconds) |
|---|---|---|
| Example 1 | 0.3 | 46 |
| Example 2 | 0.5 | 50 |
| Example 3 | 0.4 | 46 |
| Example 4 | 0.4 | 45 |
| Example 5 | 0.3 | 47 |
| Example 6 | 0.3 | 46 |
| Comparative Example 1 | 2.0 | 110 |
| Comparative Example 2 | 1.3 | 100 |
| Note) Temperature-difference: temperature-difference between the highest temperature and the lowest temperature | | |

In the ceramic substrates of Examples 1 to 6, their temperature-differences thereof measured with the thermoviewer were as small as 0.5 °C or lower, and their recovery times until its recovery to 200 °C were as short as 50 seconds or less. On the other hand, in Comparative Examples 1,2, their recovery times and the temperature-differences were large.

### Industrial Applicability

As described above, according to the first and second aspects of the ceramic heaters of the present invention, the temperature of an object to be heated can be correctly measured. By adjusting the state of heating of its heating element on the basis of the measured result of the temperature, the whole of a silicon wafer can be uniformly heated.

## Claims

1. A ceramic heater comprising a ceramic plate and a heating element formed on a surface of said ceramic plate or inside thereof,
wherein:
a bottomed hole is made, being directed from the opposite side to a heating surface for heating an object to be heated, toward the heating surface;
the bottom of said bottomed hole is formed relatively nearer to the heating surface than the heating element;
and a temperature-measuring element is set up in said bottomed hole.

2. The ceramic heater according to claim 1,
wherein the distance between the bottom of said bottomed hole and said heating surface is from 0.1 mm to 1/2 of the thickness of the ceramic plate.

3. The ceramic heater according to claim 1,
wherein the ceramic constituting said ceramic heater is a nitride ceramic or a carbide ceramic.

4. The ceramic heater according to claim 1,
wherein said heating element is divided into at least two circuits.

5. The ceramic heater according to claim 1,
wherein said heating element has a section in a flat shape.

6. A ceramic heater comprising a ceramic plate and a heating element formed on a surface of said ceramic plate or inside thereof, said ceramic heater being equipped with:
a temperature-measuring element for measuring the temperature of said ceramic plate;
a control unit for supplying electric power to said heating element;
a memory unit for memorizing the data of a temperature measured by said temperature-measuring element; and
an operation unit for calculating electric power required for said heating element from said temperature data,
wherein:
a bottomed hole is made, being directed from the opposite side to a heating surface for heating an object to be heated, toward the heating surface;
the bottom of said bottomed hole is formed relatively nearer to the heating surface than the heating element;
and a temperature-measuring element is set up in said bottomed hole.

7. The ceramic heater according to claim 6,
wherein said heating element is divided into at least two circuits and different electric powers are supplied to the respective circuits.

8. The ceramic heater according to any of claims 1 to 7,
wherein said temperature-measuring element is a sheath type thermocouple.

9. The ceramic heater according to any of claims 1 to 8,
wherein said temperature-measuring element is pressed on the bottom portion of the bottomed hole.

10. The ceramic heater according to claim 9,
wherein said temperature-measuring element is pressed thereon, by means of an elastic body or a screw.

11. The ceramic heater according to any of claims 1 to 10,
wherein said temperature-measuring element is sealed in the bottomed hole with an insulator.
